# EUROPEAN PATENT APPLICATION

(11) **EP 3 361 846 A1**
(43) Date of publication of application: **15.08.2018**
(21) Application number: 18155671.3
(22) Date of filing: 08.02.2018
(51) Int. Cl.: H05K 7/14

(54) **CABLE MANAGEMENT DEVICE**

(30) Priority: 13.02.2017 EP 17155875
(71) Applicant: Reichle & De-Massari AG, 8620 Wetzikon (CH)
(72) Inventor: FRANZKE, Jörg, 8623 Wetzikon (CH); DIMITROV, Nikola, 6600 Kardzhali (BG); LENDI, Christian, 8625 Gossau (CH)
(74) Representative: Daub, Thomas

(57) **Abstract**

The invention is based on a cable management device (10), in particular for use in conjunction with a network switch (12) and/or a patch panel (14), comprising at least one cable management unit (16) which has a modular structure and defines at least one receiving region (18) with at least one vertically aligned module slot (20) for receiving at least one cable module (22, 24).

## Description

### State of the art

The invention is based on a cable management device according to claim 1.

From the state of the art blade cabling management devices for use between a network switch and a plurality of servers are known.

The objective of the invention is in particular to make a generic cable management device available that has improved characteristics regarding flexibility. The objective is achieved by the features of claim 1, while advantageous implementations and further developments of the invention may be gathered from the subclaims.

### Advantages of the invention

The invention relates to a cable management device, preferably a blade cabling management device, in particular for use in conjunction with a network switch and/or a patch panel, comprising at least one cable management unit which has a modular structure and defines at least one, preferably exactly one, receiving region with at least one vertically aligned module slot for receiving at least one cable module.

A "cable management device" is to be understood, in this context, in particular at least as a portion, in particular a sub-assembly, of a cable management system, in particular a blade cabling management system, preferably for use in a data center. Herein, the cable management device is preferably located between a network switch and/or a patch panel and at least one server and more preferably a plurality of servers. In particular, the cable management device is configured for supporting an interconnection between the network switch and/or the patch panel and the at least one server. For this purpose, the cable management device may in particular also comprise at least one cable, preferably optical waveguide cable, and/or at least one carrier unit, which may preferably be embodied as a rack and which is in particular configured for fastening the cable management unit at least indirectly and/or directly. Furthermore, the cable management system may in particular also comprise at least one network switch, in particular the aforementioned network switch, at least one patch panel, in particular the aforementioned patch panel, and/or at least one server, in particular the aforementioned server. "Configured" is in particular to mean specifically designed and/or equipped. By an object being configured for a certain function, it is in particular to be understood that the object fulfills and/or implements this certain function in at least one application state and/or operating state. Moreover, a "cable management unit" is in particular to be understood as a unit which is in particular embodied separately from the network switch, the patch panel and/or the server and which is in particular, in at least one operating state, configured for managing, in particular guiding, connecting, coupling and/or distributing cables, advantageously a plurality of cables, preferably optical waveguide cables. In particular, the cable management unit herein comprises at least one frame unit, in particular a chassis and/or exterior housing, which can preferably be fastened to the carrier unit and which is configured to at least partly and preferably at least largely delimit the receiving region. Advantageously, the cable management unit is configured for a horizontal and a vertical installation and/or is embodied in such a way that it can be used horizontally and vertically. In addition, the cable management unit could be embodied, for example, as a 10-inch insert, as a 21-inch insert, as a 24-inch insert and/or as any other insert, in particular for connecting to an, in particular standard, 10-inch rack, 21-inch rack, 24-inch rack and/or any other rack. It is, however, advantageously proposed that the cable management unit is embodied as a 19-inch insert, in particular for connecting to an, in particular standard, 19-inch rack. In this case, a total width of the cable management unit is 482.6 mm. Moreover, preferably a width of the cable management unit from a first side wall of the frame unit to a second side wall of the frame unit is 448 mm. Furthermore, the cable management unit could have a height between 1 U and 3 U. However, preferably the cable management unit has a height of 2 U. One "U" herein corresponds in particular to one height unit (HE) and/or 44.45 mm. The term "at least largely" is herein to mean, in particular, by at least 55 %, advantageously by at least 65 %, preferably by at least 75 %, particularly preferentially by at least 85 % and especially advantageously by at least 95 %.

By the expression "having a modular structure" is herein to be understood, in particular, that the cable management unit itself and/or at least one structural component of the cable management unit has a modular structure and/or is implemented in such a way that it can be assembled modularly, for example like in a construction kit. In particular, herein at least one structural component of the cable management unit can be replaced by at least one further structural component, advantageously of the same type. "Objects of the same type" are to be understood, in this context, in particular as objects having the same construction and/or the same design but at least partly differing from each other in particular regarding their functionality, their inner structure and/or their dimensions, for instance a material thickness, a width and/or a height. Particularly preferably, the cable management unit is herein extendable and/or reducible in any required way. Moreover, a "module slot" is to be understood in particular as a depression and/or a recess which preferably features a rectangular shape and which is in particular configured to receive and/or accommodate at least one cable module in particular in such a way that the cable module is securely located in the module slot, in a mounted state. In addition, the term "vertically aligned" in particular refers to a width and/or a main extension of the cable management unit, in particular a front side of the cable management unit, in particular in a mounted state and with respect to an intended installation position and/or orientation. Thus, a "vertically aligned object" is in particular to mean an object having a main extension which is aligned perpendicularly with respect to the width and/or the main extension of the cable management unit. The term "main extension" in particular refers to an extension of an object in a main direction of extension of the object. By a "main direction of extension" of an object, is in particular a direction to be understood which is parallel to a largest edge and/or side of a smallest, in particular imaginary, rectangular cuboid which encloses the object just still completely. Advantageously, the cable management unit comprises a plurality, preferably at least eight, more preferably at least ten and most preferably at least twelve vertically aligned module slots. Herein, the module slots are preferably located adjacent to each other and/or one beside the other, in particular with respect to the width of the cable management unit. More preferably, the module slots are embodied at least substantially identically to each other. The phrasing "at least substantially identically" is herein in particular to mean identically aside from manufacturing tolerances and/or within the range of manufacturing-associated possibilities and/or within the range of standardized tolerances. Furthermore, a "cable module" is in particular to be understood as a, preferably selectively usable, unit, in particular an insert, which is in a mounted state in particular located in the receiving region, in particular in one of the module slots, and which is preferably configured for providing and/or supporting a connection functionality and/or a connection capability between the network switch and/or the patch panel and the at least one server. For this purpose, the cable module is preferably configured for guiding, connecting, coupling and/or distributing at least one cable, which in particular directly and/or indirectly connects the network switch and/or the patch panel and the at least one server. Particularly preferably, the cable management unit comprises the cable module and preferably a plurality of cable modules. More preferably, in a fully loaded state a number of cable modules matches a number of module slots. By this implementation a generic cable management device may be made available with improved characteristics as regards flexibility, in particular a flexible cable management. In this regard, an advantageously flexibly usable and/or adaptable cable management device can be made available. Moreover, an efficiency, in particular a construction space efficiency, a performance efficiency, a component efficiency and/or a cost efficiency, may be improved advantageously.

It is further proposed that the module slot, preferably each of the module slots, is configured to support and in particular accommodate at least two different types of cable modules. In this context, the term "different types of cable modules" is herein to mean that the cable modules are differently implemented and at least partly differ from each other in particular regarding their functionality. Herein, at least one first cable module is preferably embodied as a direct-connection module and is in particular configured for supporting a direct connection between the network switch and/or the patch panel and the at least one server. Furthermore, preferably at least one second cable module is embodied as an interconnection module and in particular configured for supporting an interconnection between the network switch and/or the patch panel and the at least one server. Alternatively or additionally, the module slot, preferably each of the module slots, may be configured to support at least three and/or at least four different types of cable modules. In this way in particular a cable management device with an improved flexibility may be achieved. Herein, the cable management device may in particular be individually adapted to different needs of users.

Moreover, it is proposed that the cable management unit comprises at least one first cable module located, in a mounted state, in the receiving region, in particular in the module slot and/or one of the module slots, wherein the first cable module is embodied as a direct-connection module and is configured at least for guiding at least one cable and more preferably for a fan-out of at least one cable. In this way, in particular an adequate and/or clean guidance of the cable, in particular between the network switch and/or the patch panel and the at least one server, may be achieved.

A particularly high flexibility and/or connection variety may be obtained if the cable management unit comprises at least one second cable module located, in a mounted state, in the receiving region, in particular in the module slot and/or one of the module slots, wherein the second cable module is embodied as an interconnection module having at least one connector and preferably configured for a cabling and/or connection of at least one cable.

It is moreover proposed that the module slot, preferably each module slot, is configured for mounting and/or demounting the cable module from a rear side, advantageously by way of a linear movement. Herein, the cable management unit in particular comprises at least one cable module, in particular said direct-connection module and/or said interconnection module, wherein the cable module is insertable into the module slot from a rear side for mounting, advantageously by way of a linear movement, and/or is removable out of the module slot from a rear side for demounting, advantageously by way of a linear movement. Additionally or alternatively at least one module slot may be configured for mounting and/or demounting the cable module from a front side. Particularly advantageously, the cable module, preferably each cable module, is herein releasable, connectable and/or replaceable individually and independently from further cable modules. This allows achieving a particularly flexible mounting and/or demounting of a cable module, in particular without affecting a front cabling of the cable management unit.

In a preferred embodiment of the invention it is proposed that the receiving region extends at least largely and preferably completely over an entire width of the cable management unit and comprises at least ten, preferably at least twelve and particularly preferably exactly twelve, vertically aligned module slots. As a result of this, in particular, an installation space efficiency can be improved, advantageously by using the entire width of the cable management unit.

Furthermore, it is proposed that the cable management unit comprises at least one frame unit, in particular the aforementioned frame unit, and at least one inner delimiting unit adjoining the frame unit, in particular an inner side of the frame unit, and, in particular directly, delimiting the receiving region, in particular the module slot and preferably each of the module slots. The inner delimiting unit is in particular embodied separately from the frame unit and/or differing from a mere coating and is preferably fastened to the frame unit, in particular to the inner side of the frame unit. Preferably, the frame unit and the inner delimiting unit are embodied at least largely and preferably completely of different materials. More preferably, the inner delimiting unit is embodied at least largely and preferably completely of a non-metallic material, in particular a rubber material and/or preferably a plastic material. In addition, the inner delimiting unit advantageously has a modular structure and comprises a plurality of inner delimiting elements, which are preferably embodied separately and are more preferably embodied as injection-molded parts. Herein, the inner delimiting elements are preferably embodied as horizontally aligned slider elements, in particular upper slider elements and lower slider elements, which are in particular configured for guiding a cable module, and as vertically aligned wall elements, in particular lefthand wall elements and righthand wall elements, which are in particular configured for separating a cable module from other cable modules and/or from the frame unit. As a result of this, in particular an advantageously flexible cable management unit can be provided that is at the same time particularly efficient, in particular construction-space efficient, manufacturing efficient and/or cost-efficient.

Advantageously, the cable management unit comprises at least one front-side cable manager unit, which is configured in at least one operating state to feed at least one cable, advantageously a plurality of cables, advantageously optical waveguide cables, to a front side of the cable module. Herein a "front-side cable manager unit" is in particular to be understood as a unit which is arranged in a region of a front side of the cable management unit and is preferably in connection with the front side of the cable management unit, and which is in particular configured to at least partially guide and/or hold the at least one cable, preferably a plurality of cables. Advantageously, the front side cable manager unit is stationary and/or immovable with respect to the frame unit and/or the inner delimiting unit. More advantageously, the front-side cable manager unit comprises at least two front-side cable manager elements which are offset with respect to each other in a vertical direction, in particular with respect to the width of the cable management unit. In addition, the front-side cable manager unit may, in particular, comprise at least one front-side receiving zone for receiving a display unit and/or an identification unit, for example a label holder and/or a slot for a guide light. This allows achieving in particular an especially efficient, flexible and/or clean cable guidance. Moreover, possible maximum bending radiuses of the cables may advantageously be maintained.

It is further proposed that the front-side cable manager unit is connected to, preferably attached to, the inner delimiting unit. Herein, at least one front-side cable manager element is preferably connected to, more preferably fastened to, at least one of the inner delimiting elements and preferably at least one of the slider elements. In addition, it is conceivable that the front-side cable manager unit and/or at least one front-side cable manager element is connected to the inner delimiting unit and/or at least one inner delimiting element in a one-part implementation, in particular in such a way that the front-side cable manager unit and/or the front-side cable manager element and the inner delimiting unit and/or the inner delimiting element form a common structural component. "In a one-part implementation" is in particular to mean, in this context, at least connected by substance-to-substance bond. The substance-to-substance bond may be established, for example, by an adhesive-bonding process, an injection-molding process, a welding process, a soldering process and/or another type of process. Advantageously "a one-part implementation" is to mean formed of one piece and/or in one piece. Preferentially said one piece is made from one single blank, one mass and/or one cast, e.g. in an extrusion procedure, in particular a one-component and/or multi-component extrusion procedure, and/or in an injection-molding procedure, in particular a one-component and/or multi-component injection-molding procedure. As a result, in particular a manufacturing process may be improved and/or costs may be reduced. In addition, a flexible cable guidance can be obtained.

Furthermore, it is proposed that the cable management unit comprises at least one rear-side cable manager unit, which is configured in at least one operating state to feed at least one cable, advantageously a plurality of cables, advantageously optical waveguide cables, to a rear side of the cable module. Herein a "rear-side cable manager unit" is in particular to be understood as a unit which is arranged in a region of a rear side of the cable management unit, which is situated opposite the front side of the cable management unit, and which is preferably is connection with the rear side of the cable management unit, and which is in particular configured to at least partially guide and/or hold the at least one cable, preferably a plurality of cables. Advantageously, the rear side cable manager unit is, in at least one operating state, movable with respect to the frame unit and/or the inner delimiting unit. More advantageously, the rear-side cable manager unit comprises at least one locking element, which is in at least one further operating state preferably connected and/or secured to the frame unit and/or the inner delimiting unit. More preferably, the locking element is herein located at a rear side of the rear-side cable manager unit and most preferably movable in a vertical direction, in particular with respect to the width of the cable management unit, for unlocking. More advantageously, the rear-side cable manager unit comprises at least one cable guiding element, e.g. a cable divider and/or a stress relief element, in particular for a stress relief of the at least one cable. In addition, the rear-side cable manager unit may preferably define at least one cable overlength receiving region, in particular for receiving an overlength of the at least one cable. In this way in particular an especially efficient and/or flexible cable guidance is achievable. Moreover, in particular a movement and/or a tensile stress of the at least one cable can be avoided.

A particularly simple and/or effective assembly and/or disassembly can be achieved in particular if the rear-side cable manager unit is couplable to the cable module for mounting and/or demounting of the cable module, in particular in the module slot and/or one of the module slots, preferably from the rear side. More preferably, the rear-side cable manager unit can be coupled selectively to each of the cable modules and in particular each of the at least two cable modules of different type, in particular the direct-connection module and the interconnection module, for mounting and/or demounting of the respective cable module. For this purpose, the rear-side cable manager unit and/or the cable module preferably comprise/comprises at least one coupling element, which is advantageously embodied as a hook element, a hook receptacle, a pin element and/or a pin receptacle. In particular, it is also conceivable that, for mounting and/or demounting of the cable module, in particular from the rear side, a plurality of cable modules can be coupled to one rear-side cable manager unit simultaneously and/or a plurality of rear-side cable manager units can be coupled to one cable module simultaneously.

If the rear-side cable manager unit has a modular structure, in particular a flexibility of the cable management device can be further improved.

In a preferred implementation of the invention it is proposed that the rear-side cable manager unit provides at least four, preferably at least six and most preferably at least nine connection recesses for selectively connecting cable guiding elements, e.g. cable dividers and/or a stress relief elements, in different positions. The connection recesses preferably comprise a rectangular, more preferably a square, shape, advantageously with an extension between 8 mm and 10 mm and most advantageously of 9 mm. Particularly preferably, the connection recesses are embodied at least substantially identically to each other. Furthermore, the connection recesses are advantageously spaced apart from each other, in particular in such a way that a minimal distance between the connection recesses is at least 1 cm, preferably at least 3 cm and more preferably at least 5 cm, and/or at most 10 cm, more preferably at most 8 cm and most preferably at most 6 cm in a depth direction and/or in a direction which is perpendicular to the front side of the cable management unit, and/or at least 0.2 cm, preferably at least 0.4 cm and more preferably at least 0.6 cm, and/or at most 1.2 cm, more preferably at most 1 cm and most preferably at most 0.8 cm in a width direction and/or in a direction which is parallel to the front side of the cable management unit. More preferably, at least two of the connection recesses and advantageously at least three of the connection recesses are offset with respect to each other in a depth direction and/or in a direction which is perpendicular to the front side of the cable management unit. Moreover, the rear-side cable manager unit may in this case also comprise the aforementioned cable guiding elements. As a result, an advantageously modular structure may be achieved. Moreover, in particular a flexible fan-out and/or movement compensation of the cable modules and/or of the cables connected to the cable modules may be achieved.

In a further implementation of the invention it is proposed that the cable management unit comprises at least one, advantageously exactly one, protective element, which is configured in at least one operating state to at least partly, preferably at least largely and more preferably completely, cover the receiving region and in particular the module slot, preferably each of the module slots, in particular at least if viewed perpendicularly to the front side of the cable management unit. In particular, the protective element is arranged in a region of the front side of the cable management unit. Herein, the protective element could be pivotable about a vertically aligned pivot axis and/or exactly one horizontally aligned pivot axis, in particular with respect to the frame unit. However, advantageously it is proposed that the protective element is pivotable about two different horizontally aligned pivot axes, in particular with respect to the frame unit, which are offset in a vertical direction with respect to each other, in particular with respect to the width of the cable management unit. As a result of this, in particular, a protection efficiency can be improved, advantageously allowing an avoidance of an operator inadvertently touching cables and/or connector elements. Moreover, an advantageously flexible protective element may be provided which is individually operable.

Advantageously, it is proposed that the cable management unit comprises at least one functional unit receiving zone, which is allocated and/or associated to at least one cable module and is configured to receive at least one, advantageously exactly one, electrical and/or electronical functional unit, which in particular differs from a cable module, from a front-side cable manager unit, from a rear-side cable manager unit and from a protective element. Preferably, the functional unit receiving zone is arranged in a region of the rear side of the cable management unit. The functional unit may herein be implemented as any type of functional unit, e.g. as a monitoring unit, in particular to indicate a presence of a cable and/or a connector, as a display unit, in particular to display at least one signal of the monitoring unit, as a supply unit, in particular for a power supply of the monitoring unit, and/or as a control unit, in particular for controlling the monitoring unit. This allows in particular enhancing a multi-purpose aspect of the cable management device.

Herein, the cable management device is not to be restricted to the application and implementation form mentioned above. In particular, for the purpose of producing the cable management device for fulfilling a functionality herein described, the cable management device may comprise a respective number of individual elements, structural components and units that differs from the number mentioned.

### Drawings

Further advantages may be gathered from the following description of the drawings. In the drawings one exemplary embodiment of the invention is shown. The drawings, the description and the claims contain a plurality of features in combination. The person having ordinary skill in the art will purposefully also consider the features separately and will find further expedient combinations.

It is shown in:
- Fig. 1: a schematic view of an exemplary cable management system with a cable management device,
- Fig. 2: a perspective view of the cable management device comprising a cable management unit,
- Figs. 3a-c: a major portion of the cable management unit, in various views,
- Figs. 4a-b: a frame unit of the cable management unit, in various views,
- Figs. 5a-f: a front-side cable manager unit of the cable management unit and an inner delimiting unit of the cable management unit comprising several inner delimiting elements, in various views,
- Figs. 6a-e: a first cable module and a second cable module of the cable management unit, in various perspective views,
- Fig. 7: a cover element of the cable management unit, in a perspective view,
- Figs. 8a-b: a rear-side cable manager unit of the cable management unit, in perspective views,
- Figs. 9a-c: a presentation of a coupling process between the rear-side cable manager unit and one of the cable modules for mounting the respective cable module from a rear side,
- Figs. 9d-e: an alternative rear-side cable manager unit and an alternative cable module of the cable management unit in a mounted state, in perspective views,
- Figs. 10a-d: a protective element of the cable management unit, in various views,
- Figs. 11a-b: a functional unit receiving zone arranged in a region of a rear side of the cable management unit and a functional unit of the cable management unit, in various views, and
- Figs 12a-b: two different fastening elements of the cable management device for fastening the cable management unit.

### Description of the exemplary embodiment

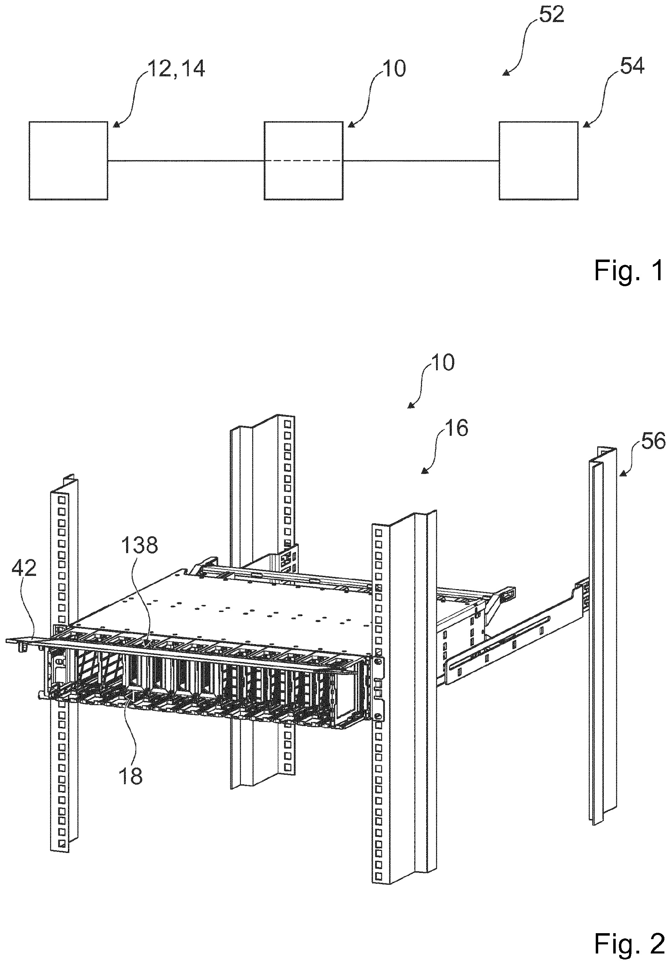

Figure 1 schematically shows a cable management system 52 with a cable management device 10. The cable management device 10 is configured for use in conjunction with a network switch 12 and/or a patch panel 14. Herein, the cable management device 10 is located between the network switch 12 and/or the patch panel 14 and at least one server 54. The cable management device 10 is configured for supporting an interconnection between the network switch 12 and/or the patch panel 14 and the at least one server 54.

Figure 2 shows the cable management device 10 in a perspective view. The cable management device 10 is embodied as a blade cabling management device. The cable management device 10 comprises at least one cable management unit 16. In the present case, the cable management device 10 comprises exactly one cable management unit 16. The cable management unit 16 has a modular structure. The cable management unit 16 is embodied separately from the network switch 12 and/or the patch panel 14. The cable management unit 16 is further embodied separately from the server 54. The cable management unit 16 is configured for managing cables, which are preferably embodied as optical waveguide cables and which directly and/or indirectly connect the network switch 12 and/or the patch panel 14 and the server 54. However, it is also conceivable to use cables that differ from optical waveguide cables, e.g. electric cables.

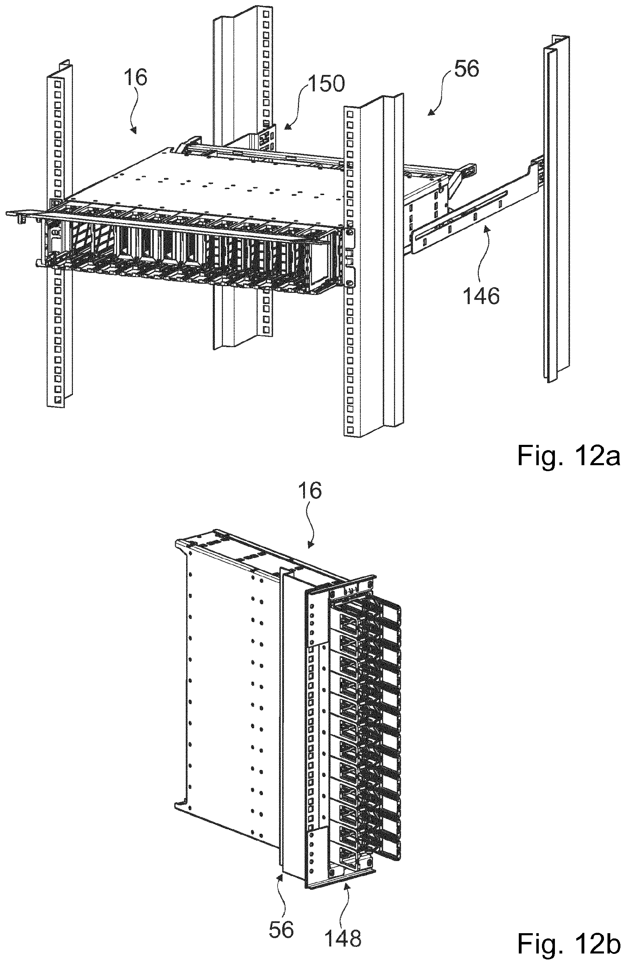

The cable management unit 16 is moreover intended to be used in a carrier unit 56, in the present case in particular in a 19-inch standard rack. Herein, the cable management unit 16 is installed horizontally. Thus, the cable management unit 16 is in the present case embodied as a 19-inch insert wherein a width of the cable management unit 16 is 482.6 mm. However, in the present case the cable management unit 16 is embodied in such a way that it can be used and installed horizontally as well as vertically (cf. also figures 12a and 12b). Furthermore, the cable management unit 16 has a height of 2 U and/or 88.9 mm. Principally, however, it is also conceivable to implement a carrier unit as any other type of carrier unit, advantageously as any other rack. Herein, it is also conceivable to implement a cable management unit, for example, as a 10-inch insert, as a 21-inch insert and/or as a 24-inch insert. Moreover, a cable management unit could have a height of 1 U, 3 U, 4 U and/or any other height.

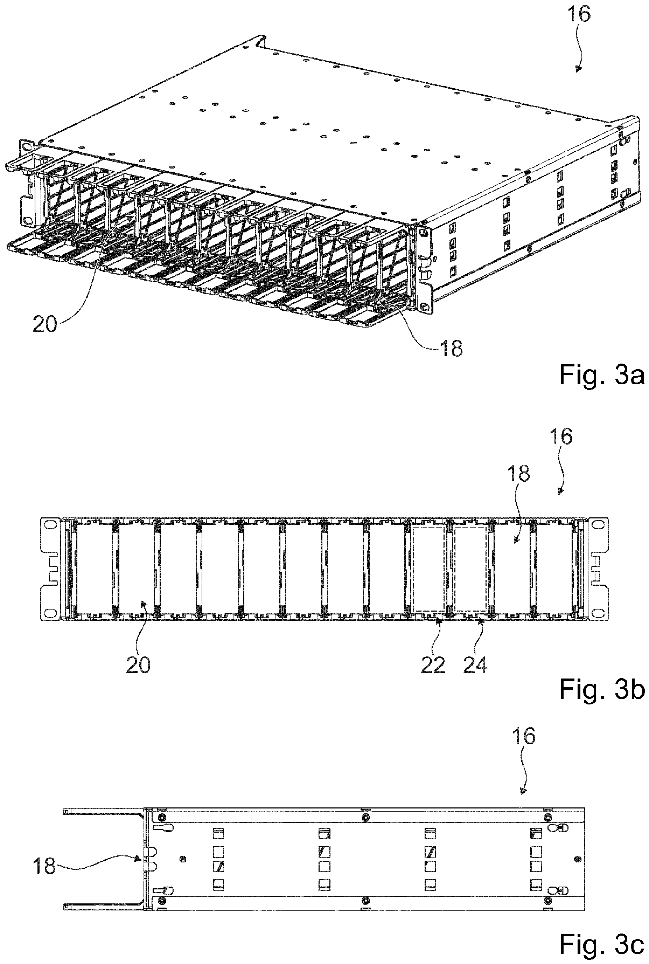

Moreover, the cable management unit 16 defines a receiving region 18 with a plurality of vertically aligned module slots 20 each for receiving exactly one cable module 22, 24 (cf. also figures 3a to 3c). Herein, the receiving region 18 extends over an entire width of the cable management unit 16. Moreover, in the present case the receiving region 18 comprises twelve separate, vertically aligned module slots 20 one beside the other. The module slots 20 are embodied at least substantially identically to each other. Each of the module slots 20 has a rectangular shape. Each of the module slots 20 has a width, in particular in a direction of the width of the cable management unit 16, of approximately 30.5 mm. Each of the module slots 20 has a height, in particular in a direction of the height of the cable management unit 16, which at least largely extends over an entire height of the cable management unit 16. In addition, each module slot 20 is configured to support at least two different types of cable modules 22, 24, in particular at least one first cable module 22 and at least one second cable module 24. Herein, each module slot 20 is configured to accommodate in a mounted state at least two different types of cable modules 22, 24 in such a way that the cable modules 22, 24 are securely located in the module slot 20. The module slots 20 are further at least configured for mounting and demounting the cable modules 22, 24 from a rear side. Alternatively, a receiving region may also merely extend over a portion of a width of a cable management unit and/or may comprise eight or ten module slots. Moreover, it is conceivable that at least one module slot is configured for mounting and/or demounting a cable module from a front side.

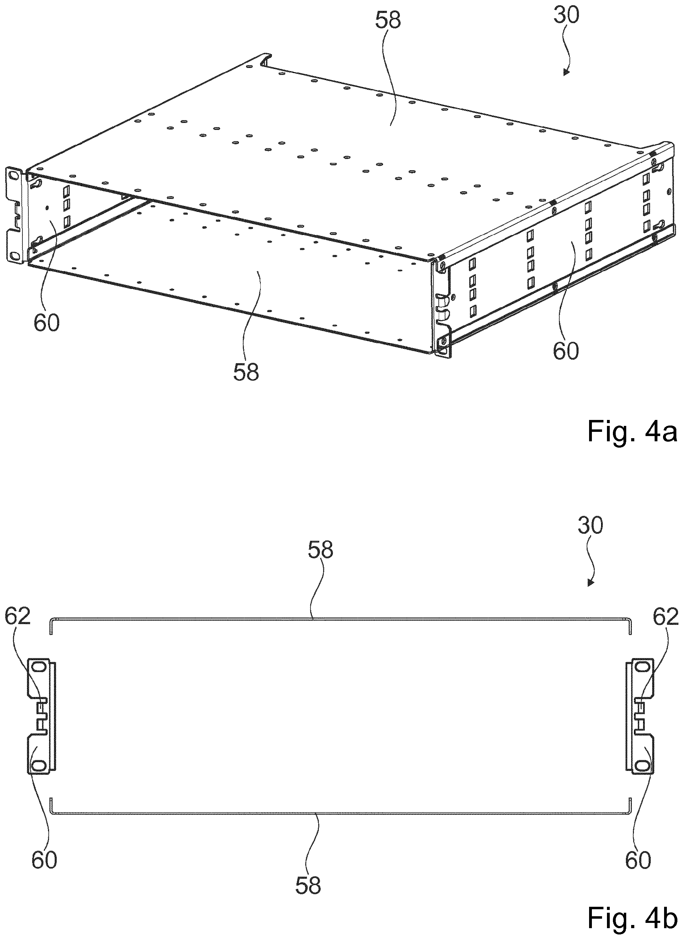

In particular for defining and/or delimiting the receiving region 18, the cable management unit 16 comprises a frame unit 30 (cf. also figures 4a and 4b). The frame unit 30 is embodied as a chassis. The frame unit 30 forms an outer housing of the cable management unit 16. Moreover, the frame unit 30 is in the present case made of metal, in particular metal sheets. Alternatively, a frame unit may be made at least partly of a plastic material.

The frame unit 30 comprises two cover plates 58. The cover plates 58 are embodied at least substantially identically to each other. The cover plates 58 are respectively embodied at least substantially rectangular, in particular if viewed perpendicularly to a main extension plane of the cover plates 58, preferably with a rear-side depression. One cover plate 58 of the cover plates 58 forms and/or defines a lower side of the frame unit 30 and in particular of the cable management unit 16. A further cover plate 58 of the cover plates 58 forms and/or defines an upper side of the frame unit 30 and in particular of the cable management unit 16. The cover plates 58 thus delimit the height of the frame unit 30 and in particular of the cable management unit 16.

The frame unit 30 further comprises two side walls 60. The side walls 60 are embodied as lateral side walls. The side walls 60 are embodied at least substantially identical to each other. The side walls 60 are embodied at least substantially rectangular, in particular if viewed perpendicularly to a main extension plane of the side walls 60. The side walls 60 are embodied at least substantially L-shaped. A large side of the side walls 60 and/or the L-shape forms and/or defines herein a side of the frame unit 30 and in particular of the cable management unit 16. A small side of the side walls 60 and/or the L-shape forms and/or defines a fastening section, in particular for a front-side fastening of the frame unit 30 and in particular of the cable management unit 16 to the carrier unit 56. In the present case, each fastening section comprises at least one auxiliary fastening element 62, which is at least substantially lug-shaped and/or tongue-shaped and which is configured to simplify a fastening of the frame unit 30 and in particular of the cable management unit 16 to the carrier unit 56. The side walls 60 thus delimit a width of the frame unit 30 and in particular of the cable management unit 16. As an alternative it is, however, also conceivable to dispense with auxiliary fastening elements.

The cover plates 58 and the side walls 60 can be coupled to each other by way of any fastening method. In the present case, the cover plates 58 and the side walls 60 are at least partially connected to each other by means of screw connections. However, it is also suitable to use other fastening methods and/or to embody a frame unit in a one-part implementation.

Moreover, the frame unit 30 has a modular structure such that the cover plates 58 and/or the side walls 60 are selectable from a group of cover plates 58 and/or side walls 60, depending on a width and/or a height of the frame unit 30. In the present case, a width and a height of the frame unit 30 is at least substantially selectable according to any requirements. Accordingly, the cable management unit 16 has in the present case a modular structure and can, in particular, be varied at least as regards width and/or height.

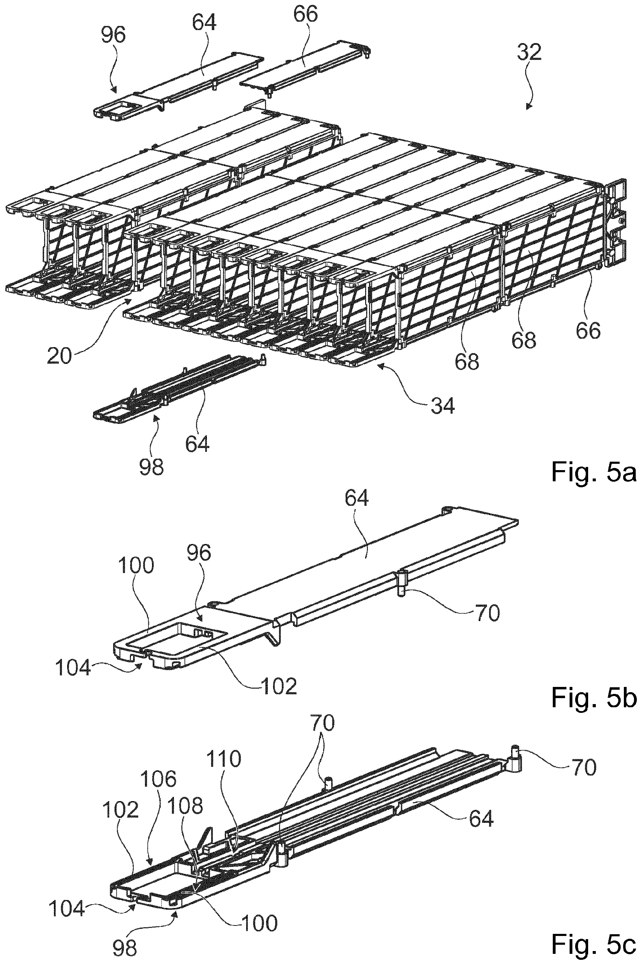

In addition, the cable management unit 16 comprises an inner delimiting unit 32 (cf. also figures 5a to 5f). The inner delimiting unit 32 has a modular structure. The inner delimiting unit 32 is embodied separately from the frame unit 30. The inner delimiting unit 32 is arranged at least largely between the cover plates 58 and the side walls 60. The inner delimiting unit 32 is arranged in a proximity of an inner side of the frame unit 30. The inner delimiting unit 32 directly adjoins the inner side of the frame unit 30. The inner delimiting unit 32 is adapted at least substantially to a shape and/or contour, in particular to a width, a height and a depth, of the frame unit 30. The inner delimiting unit 32 is in a mounted state stationary and/or immovable with respect to the frame unit 30. Herein, the inner delimiting unit 32 is fastened to the frame unit 30. Furthermore, the inner delimiting unit 32 is embodied of a non-metallic material. In the present case, the inner delimiting unit 32 is made of plastic. Thus, the inner delimiting unit 32 and the frame unit 30 are embodied of different materials. As an alternative, it is also conceivable to embody a frame unit and an inner delimiting unit in a one-part implementation. Moreover, an inner delimiting unit may be made at least partly of other materials, e.g. rubber. Moreover, principally an inner delimiting unit may be movable with respect to a frame unit. The inner delimiting unit 32 directly delimits and separates the module slots 20 off. Moreover, the inner delimiting unit 32 simplifies a mounting and/or demounting of the cable modules 22, 24, in particular by guiding the cable modules 22, 24.

For this purpose, the inner delimiting unit 32 comprises a plurality of inner delimiting elements 64, 66, 68. In the present case, the inner delimiting unit 32 comprises three groups of inner delimiting elements 64, 66, 68, which are embodied differently, in particular first inner delimiting elements 64, second inner delimiting elements 66 and third inner delimiting elements 68. The inner delimiting elements 64, 66, 68 are embodied separately from each other. Each of the inner delimiting elements 64, 66, 68 is embodied in a one-part implementation. The inner delimiting elements 64, 66, 68 are embodied as injection-molded parts. The inner delimiting elements 64, 66, 68 can be coupled to each other by way of any fastening method. In the present case, the inner delimiting elements 64, 66, 68 are at least partially connected to each other by a pushfit and/or pin connection. However, it is also suitable to use other fastening methods, like glue connections and/or screw connections.

The first inner delimiting elements 64 are arranged in a region of a front side of the frame unit 30 and in particular of the cable management unit 16 (cf. figures 5b and 5c). The first inner delimiting elements 64 are embodied at least substantially identically to each other. The first inner delimiting elements 64 are respectively embodied at least substantially rectangular, in particular if viewed perpendicularly to a main extension plane of the first inner delimiting elements 64. Moreover, the first inner delimiting elements 64 are aligned horizontally. Thus, main extension planes of the first inner delimiting elements 64 are in a mounted state oriented at least substantially in parallel to the main extension plane of the cover plates 58.

The first inner delimiting elements 64 are embodied as first slider elements, in particular as front slider elements. The first inner delimiting elements 64 form upper and lower front slider elements. In the present case, two of the first inner delimiting elements 64, in particular one upper and one lower front slider element, are allocated to one of the module slots 20. Herein, a width of the first inner delimiting elements 64 is at least substantially equivalent to a width of the cable modules 22, 24. Thus, the inner delimiting unit 32 comprises twenty-four first inner delimiting elements 64.

Moreover, each of the first inner delimiting elements 64 comprises at least one first positioning element 70. In the present case, each of the first inner delimiting elements 64 comprises three first positioning elements 70. The first positioning elements 70 are embodied as positioning pins. The first positioning elements 70 are configured for positioning the first inner delimiting elements 64 with respect to the third inner delimiting elements 68. As an alternative, an inner delimiting unit may comprise upper and lower front slider elements which are embodied differently from each other. Moreover, it is conceivable that at least one first inner delimiting element is allocated to two module slots, three module slots and/or four module slots. Additionally, a first delimiting element may comprise a different number of first positioning elements.

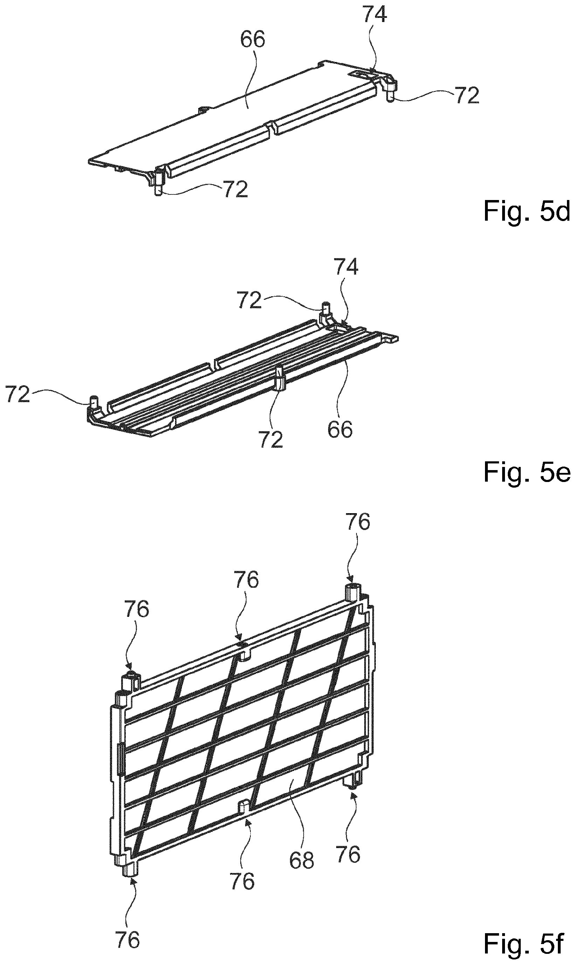

The second inner delimiting elements 66 are arranged in a region of a rear side of the frame unit 30 and in particular of the cable management unit 16 (cf. figures 5d and 5e). The second inner delimiting elements 66 are embodied at least substantially identically to each other. Moreover, the second inner delimiting elements 66 are at least substantially structurally identical to the first inner delimiting elements 64. The second inner delimiting elements 66 are respectively embodied at least substantially rectangular, in particular if viewed perpendicularly to a main extension plane of the second inner delimiting elements 66. Moreover, the second inner delimiting elements 66 are aligned horizontally. Hence, main extension planes of the second inner delimiting elements 66 are in a mounted state oriented at least substantially in parallel to the main extension planes of the cover plates 58 and/or the first inner delimiting elements 64. In the present case, the second inner delimiting elements 66 directly adjoin the first inner delimiting elements 64 in a depth direction of the cable management unit 16.

The second inner delimiting elements 66 are embodied as second slider elements, in particular as rear slider elements. The second inner delimiting elements 66 form upper and lower rear slider elements. In the present case, two of the second inner delimiting elements 66, in particular one upper and one lower rear slider element, are allocated to one of the module slots 20. Herein, a width of the second inner delimiting elements 66 is at least substantially equivalent to a width of the cable modules 22, 24. Thus, the inner delimiting unit 32 comprises twenty-four second inner delimiting elements 66.

Moreover, each of the second inner delimiting elements 66 comprises at least one second positioning element 72. In the present case, each of the second inner delimiting elements 66 comprises three second positioning elements 72. The second positioning elements 72 are embodied as positioning pins. The second positioning elements 72 are configured for positioning the second inner delimiting elements 66 with respect to the third inner delimiting elements 68.

Additionally, each of the second inner delimiting elements 66 comprises a locking recess 74. The locking recesses 74 are located at a rear side of respective second inner delimiting elements 66. As an alternative, an inner delimiting unit may comprise upper and lower rear slider elements which are embodied differently from each other. Moreover, it is conceivable that at least one second inner delimiting element is allocated to two module slots, three module slots and/or four module slots. Additionally, a second delimiting element may comprise a different number of second positioning elements and/or locking recesses. Moreover, as an alternative, it is also conceivable to dispense with first inner delimiting elements or second inner delimiting elements, in particular in order to reduce a depth of a cable management unit.

The third inner delimiting elements 68 are arranged in a region of the front side and the rear side of the frame unit 30 and in particular of the cable management unit 16 (cf. figure 5f). The third inner delimiting elements 68 are embodied at least substantially identically to each other. The third inner delimiting elements 68 are respectively embodied at least substantially rectangular, in particular if viewed perpendicularly to a main extension plane of the third inner delimiting elements 68. Moreover, the third inner delimiting elements 68 are aligned vertically. Hence, main extension planes of the third inner delimiting elements 68 are in a mounted state oriented at least substantially in parallel to the main extension plane of the side walls 60 and/or at least substantially perpendicular to the first inner delimiting elements 64 and the second inner delimiting elements 66. The third inner delimiting elements 68 are at least substantially adapted to the height of the frame unit 30. In the present case, each of the third inner delimiting elements 68 connects upper and lower front slider elements or upper and lower rear slider elements to each other.

The third inner delimiting elements 68 are embodied as wall elements, in particular lateral wall elements. The third inner delimiting elements 68 form front and rear wall elements. In the present case, four of the third inner delimiting elements 68, in particular two front and two rear wall elements, are allocated to one of the module slots 20. Herein, a distance between two adjacent third inner delimiting elements 68 is at least substantially equivalent to a width of the cable modules 22, 24. In the present case, the inner delimiting unit 32 comprises twenty-six third inner delimiting elements 68.

Moreover, each of the third inner delimiting elements 68 comprises at least one third positioning element 76. In the present case, each of the third inner delimiting elements 68 comprises six third positioning elements 76. The third positioning elements 76 are embodied as positioning depressions. The third positioning elements 76 correspond to the first positioning elements 70 and the second positioning elements 72. The third positioning elements 76 are configured for positioning the first inner delimiting elements 64 and the second inner delimiting elements 66 with respect to the third inner delimiting elements 68. As an alternative, an inner delimiting unit may comprise front and rear wall elements which are embodied differently from each other. Additionally, a third delimiting element may comprise a different number of third positioning elements. Moreover, as an alternative, it is also conceivable that an inner delimiting unit merely comprises front wall elements or rear wall elements, in particular in order to reduce a depth of a cable management unit.

In addition, the cable management unit 16 comprises at least one front-side cable manager unit 34 (cf. in particular figures 5a to 5c). In the present case, the cable management unit 16 comprises a plurality of front-side cable manager units 34 wherein each of the front-side cable manager units 34 is allocated to one of the module slots 20. The front-side cable manager units 34 are in a mounted state arranged in a region of a front side of the frame unit 30 and in particular of the cable management unit 16. The front-side cable manager units 34 are embodied at least substantially identical to each other. The front-side cable manager units 34 are connected to the inner delimiting unit 32. Therefore, the front-side cable manager units 34 are in a mounted state stationary and/or immovable with respect to the frame unit 30 and/or the inner delimiting unit 32. In the present case, the front-side cable manager units 34 directly adjoin the inner delimiting unit 32 in a depth direction of the cable management unit 16. Each front-side cable manager unit 34 is configured to guide a plurality of cables and to feed them in at least one operating state to a front side of one of the cable modules 22, 24, in particular to the cable module 22, 24 which is allocated to the respective module slot 20. As an alternative, however, it is also conceivable that front-side cable manager units differ from each other in at least one feature, and/or to entirely dispense with at least one of the front-side cable manager units. In this case, it is also conceivable to merely use one front-side cable manager unit and/or two front-side cable manager units which is/are located in a region of lateral sides of a cable management unit. It is herein moreover conceivable that a cable management unit is completely free from front-side cable manager units.

The following description will be restricted to one of the front-side cable manager units 34, wherein, due to the at least substantially identical construction of the front-side cable manager units 34, the following description may also be read on possible other front-side cable manager units 34.

The front-side cable manager unit 34 comprises at least two front-side cable manager elements 96, 98. The front-side cable manager elements 96, 98 are embodied at least substantially identically to each other. Each of the front-side cable manager elements 96, 98 is embodied in a one-part implementation. The front-side cable manager elements 96, 98 are embodied as injection-molded parts.

The front-side cable manager elements 96, 98 are aligned horizontally. Thus, main extension planes of the front-side cable manager elements 96, 98 are in a mounted state oriented at least substantially in parallel to the main extension plane of the cover plates 58. The front-side cable manager elements 96, 98 are offset with respect to each other in a vertical direction. The front-side cable manager elements 96, 98 are connected to the first inner delimiting elements 64. The front-side cable manager elements 96, 98 are connected to the first inner delimiting elements 64 in a form-fit and/or a force-fit manner. In the present case, one front-side cable manager element 96 of the front-side cable manager elements 96, 98 is connected to one of the upper front slider elements while the other front-side cable manager element 98 of the front-side cable manager elements 96, 98 is connected to one of the lower front slider elements. As an alternative, a front-side cable manager unit may also comprise exactly one front-side cable manager element. Moreover, at least one front-side cable manager element may be connected to an inner delimiting element in a one-part implementation. Furthermore, a front side cable manager element may be connected to a third inner delimiting element. Moreover, it is also conceivable that front-side cable manager elements differ from each other in at least one feature, and/or to dispense with one of the front-side cable manager elements.

Moreover, the front-side cable manager elements 96, 98 are respectively embodied at least substantially pincer-shaped. Thus, each of the front-side cable manager elements 96, 98 comprises at least two holding arms 100, 102 facing away from the inner delimiting unit 32. Herein, free ends of the holding arms 100, 102 face each other in particular in such a way that the holding arms 100, 102 define an insert opening 104, which in the present case in particular forms an oblique slot and is configured for introducing at least one cable. As an alternative, however, an insert opening may also form a straight slot and/or a V-shaped slot.

In addition, the front-side cable manager unit 34 comprises at least one front-side receiving zone 106, 108, 110. In the present case, the front-side cable manager unit 34 comprises three front-side receiving zones 106, 108, 110. A first front-side receiving zone 106 and a second front-side receiving zone 108 of the front-side receiving zones 106, 108, 110 respectively define a slot, in the present case in particular a label holder. The first front-side receiving zone 106 and the second front-side receiving zone 108 are located in a region of the holding arms 100, 102. The first front-side receiving zone 106 and the second front-side receiving zone 108 are configured for receiving a display unit, in the present case in particular a label. A third front-side receiving zone 110 of the front-side receiving zones 106, 108, 110 defines a further slot. The third front-side receiving zone 110 is located in a proximity of the inner delimiting unit 32. The third front-side receiving zone 110 is configured for receiving an identification unit, in the present case in particular a guide light. As an alternative, a front-side cable manager unit may comprise exactly one front-side receiving zone or two front-side receiving zones. In addition it is, however, also conceivable to dispense with front-side receiving zones.

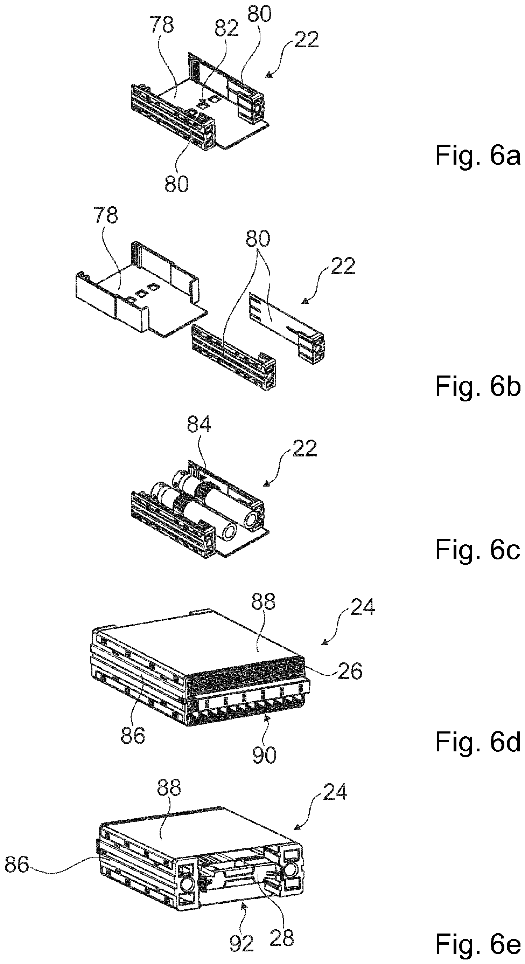

The cable management unit 16 further comprises the at least one cable module 22, 24, which is in particular located, in a mounted state, in the receiving region 18, more precisely in one of the module slots 20 (cf. in particular figures 6a to 6e). The at least one cable module 22, 24 is herein embodied as a changeable insert and is configured for providing and/or supporting a connection functionality between the network switch 12 and/or the patch panel 14 and the server 54. In the present case, the cable management unit 16 may comprise, in particular optionally, a plurality of cable modules 22, 24, in particular up to twelve cable modules 22, 24, in particular of the same type or of different types. Each of the cable modules 22, 24 is herein, with respect to the frame unit 30, releasable, connectable and/or replaceable individually and independently from the other cable modules 22, 24, in particular in any of the module slots 20. The cable modules 22, 24 are moreover at least substantially structurally identical to each other. In the present case, the cable management unit 16 comprises two different types of cable modules 22, 24, in particular at least one first cable module 22 and at least one second cable module 24, which in particular at least partly differ from each other regarding their structure and their functionality.

The first cable module 22 is shown in figures 6a to 6c. The first cable module 22 is embodied as a direct-connection module. The first cable module 22 is configured for supporting a direct connection between the network switch 12 and/or the patch panel 14 and the server 54. The first cable module 22 has a modular structure. The first cable module 22 features extensions, in particular a width, a height and a depth, which correspond to extensions of the module slots 20. In the present case, the first cable module 22 is configured for a vertical mounting. However, the first cable module 22 is embodied in such a way that it can be used and installed horizontally and vertically. The first cable module 22 is at least partly made of a plastic material. As an alternative it is, however, also conceivable to manufacture a first cable module at least partly of a material that differs from a plastic material, e.g. a metal and/or a composite material.

The first cable module 22 comprises a module base body 78. The module base body 78 is embodied in a one-part implementation. The module base body 78 is embodied as a receiving housing. The module base body 78 features an at least substantially U-shaped profile. The module base body 78 is embodied at least substantially rectangular, at least if viewed perpendicularly to a main extension plane of the module base body 78. In a mounted state, the main extension plane of the module base body 78 is oriented at least substantially parallel to the main extension plane of the side walls 60 and/or of the third inner delimiting elements 68.

Furthermore, the first cable module 22 comprises two module walls 80. The module walls 80 are embodied as lateral side walls. The module walls 80 are embodied at least substantially identically to each other. Each of the module walls 80 is embodied in a one-part implementation. The module walls 80 are embodied at least substantially rectangular, in particular if viewed perpendicularly to a main extension plane of the module walls 80. The module walls 80 are fixed to the module base body 78. In the present case, the module walls 80 encompass the module base body 78 at least partly. For this purpose, the module walls 80 are embodied at least substantially hook-shaped. Herein, a large side of the module walls 80 and/or the hook-shape forms and/or defines a side of the first cable module 22. Furthermore, a small side of the module walls 80 and/or the hook-shape forms and/or defines a coupling section of the first cable module 22. In a mounted state, main extension planes of the module walls 80 are herein oriented at least substantially parallel to the main extension plane of the cover plates 58 and/or the first and second inner delimiting elements 64, 66.

The module base body 78 and the module walls 80 define a module housing of the first cable module 22. Moreover, the module base body 78 and the module walls 80 define a cable receiving region.

In the present case, the first cable module 22 is configured at least for guiding at least one cable and/or for a fan-out of at least one cable. For this purpose, the first cable module 22 provides at least one connection recess 82 and at least one cable guiding element 84, e.g. a cable divider and/or a stress relief element, which are/is selectively connected to the connection recess 82. In the present case, the first cable module 22 provides three connection recesses 82. The connection recesses 82 have a square shape with a standardized extension, which is in the present case in particular 9 mm x 9 mm. The connection recesses 82 are configured for selectively receiving the cable guiding element 84. As an alternative, a first cable module may also comprise fixedly arranged cable guiding elements and/or a plurality of cable guiding elements.

The second cable module 24 is shown in figures 6d and 6e. The second cable module 24 is embodied as an interconnection module. The second cable module 24 is configured for supporting an interconnection between the network switch 12 and/or the patch panel 14 and the server 54. The second cable module 24 has a modular structure. The second cable module 24 comprises extensions, in particular a width, a height and a depth, which correspond to extensions of the module slots 20. In addition, the second cable module 24 comprises extensions, in particular a width, a height and a depth, which correspond to extensions of the first cable module 22. In the present case, the second cable module 24 is configured for a vertical mounting. However, the second cable module 24 is embodied in such a way that it can be used and installed horizontally and vertically. The second cable module 24 is at least partly made of a plastic material. As an alternative it is, however, also conceivable to manufacture a second cable module at least partly of a material that differs from a plastic material, e.g. a metal and/or a composite material.

The second cable module 24 comprises two further module walls 86. The further module walls 86 are embodied as lateral side walls. The further module walls 86 are embodied at least substantially identically to each other. Each of the further module walls 86 is embodied in a one-part implementation. The further module walls 86 are embodied at least substantially rectangular, in particular if viewed perpendicularly to a main extension plane of the further module walls 86. The further module walls 86 are embodied at least substantially L-shaped. Herein, a large side of the further module walls 86 and/or the L-shape forms and/or defines a side of the second cable module 24. Furthermore, a small side of the further module walls 86 and/or the L-shape forms and/or defines a coupling section of the second cable module 24. In a mounted state, main extension planes of the further module walls 86 are herein oriented at least substantially parallel to the main extension plane of the cover plates 58 and/or of the first and second inner delimiting elements 64, 66. Alternatively, it is conceivable to embody further module walls and module walls at least substantially identically.

Furthermore, the second cable module 24 comprises two module covers 88. The module covers 88 are embodied at least substantially identically to each other. The module covers 88 are each embodied at least substantially rectangular, in particular if viewed perpendicularly to a main extension plane of the module covers 88. The module covers 88 are at least substantially plate-shaped. One module cover 88 of the module covers 88 forms and/or defines a lower side of the second cable module 24. A further module cover 88 of the module covers 88 forms and/or defines an upper side of the second cable module 24. Moreover, the module covers 88 can be coupled to the further module walls 86 by any fastening method, according to requirements. In the present case, the module covers 88 are connected to the further module walls 86 by means of latch connections. As an alternative it is, however, also conceivable to dispense with at least one module cover and/or to completely dispense with module covers. In this case, a connection module in particular implements an advantageously accessible module cassette.

The further module walls 86 and advantageously the module covers 88 define an, in particular closed, module housing of the second cable module 24. Moreover, the further module walls 86 and advantageously the module covers 88 define a cable receiving region. Additionally, the further module walls 86 and advantageously the module covers 88 define a front-side connection zone 90, which is in particular arranged on a side that faces away from the small side of the further module walls 86 and/or the L-shape, and a rear-side connection zone 92.

In the present case, the second cable module 24 is configured at least for a cabling and/or connection of at least one cable. For this purpose, the second cable module 24 comprises at least one connector 26, 28, e.g. an LC-Duplex plug connector and/or an MPO plug connector, which is advantageously arranged in the front-side connection zone 90 or the rear-side connection zone 92. In the present case, the second cable module 24 comprises at least two connectors 26, 28, wherein one of the connectors 26, 28 is arranged in the front-side connection zone 90 and another one of the connectors 26, 28 is arranged in the rear-side connection zone 92. As an alternative, a second cable module may also comprise merely one connector. Moreover, it is conceivable arranging an additional monitoring unit in a front side connection zone and/or a rear-side connection zone in particular for monitoring a connection and/or a function of a connector.

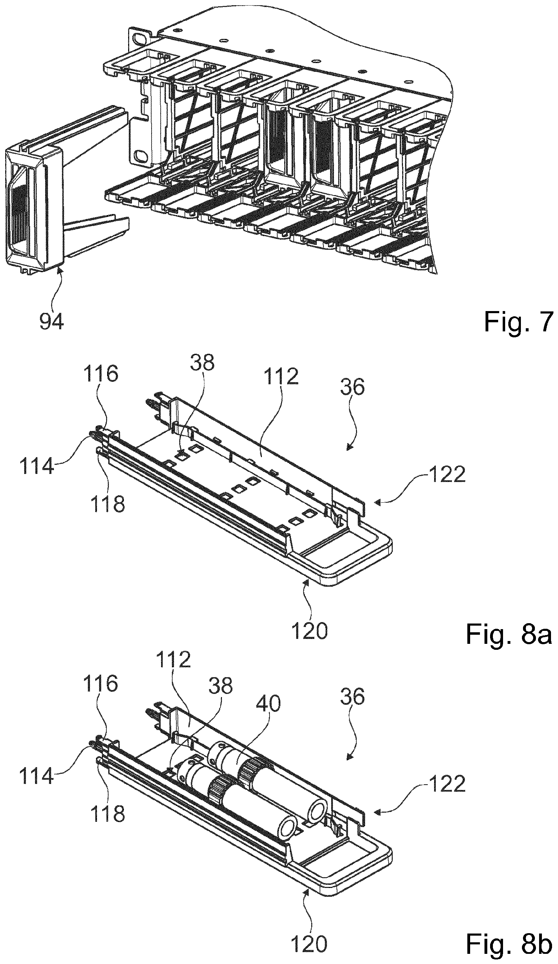

Figure 7 furthermore shows an optionally usable cover element 94 of the cable management unit 16. The cover element 94 can in particular be used instead of a cable module 22, 24 and is provided to protect the receiving region 18 and in particular one of the module slots 20.

Furthermore, the cable management unit 16 comprises at least one rear-side cable manager unit 36 (cf. in particular figures 8a to 9c). In the present case, the cable management unit 16 comprises a plurality of rear-side cable manager units 36, wherein each of the rear-side cable manager units 36 is allocated to one of the module slots 20. The rear-side cable manager units 36 are in a mounted state arranged in a region of a rear side of the frame unit 30 and in particular of the cable management unit 16. The rear-side cable manager units 36 are embodied at least substantially identical to each other. The rear-side cable manager units 36 are in a mounted state connected to the inner delimiting unit 32. However, the rear-side cable manager units 36 can be moved with respect to the frame unit 30 and/or to the inner delimiting unit 32, in at least one operating state. Each rear-side cable manager unit 36 is configured to guide a plurality of cables and to feed them in at least one operating state to a rear side of one of the cable modules 22, 24, in particular to the cable module 22, 24 which is allocated to the respective module slot 20. As an alternative, however, it is also conceivable that rear-side cable manager units differ from each other in at least one feature, and/or to entirely dispense with at least one of the rear-side cable manager units. In this case, it is also conceivable to merely use one rear-side cable manager unit and/or two rear-side cable manager units which is/are located in a region of lateral sides of a cable management unit. It is herein moreover conceivable that a cable management unit is completely free from rear-side cable manager units.

The following description will be restricted to one of the rear-side cable manager units 36, wherein due to the at least substantially identical construction of the rear-side cable manager units 36, the following description may also be read on possible other rear-side cable manager units 36.

The rear-side cable manager unit 36 is embodied in a one-part implementation. The rear-side cable manager unit 36 is made of plastic. As an alternative, however, a rear-side cable manager unit could also be embodied consisting of a plurality of parts. Moreover, it is also conceivable to manufacture a rear-side cable manager unit at least partly of a material that differs from a plastic material, e.g. a metal and/or a composite material.

The rear-side cable manager unit 36 comprises a cable manager base body 112. The cable manager base body 112 is embodied as a receiving housing. The cable manager base body 112 is embodied at least substantially rectangular-cuboidal. The cable manager base body 112 features an at least substantially U-shaped profile. The cable manager base body 112 is embodied at least substantially rectangular, at least if viewed perpendicularly to a main extension plane of the cable manager base body 112. In a mounted state, the main extension plane of the cable manager base body 112 is oriented at least substantially parallel to the main extension plane of the side walls 60 and/or of the third inner delimiting elements 68.

The rear-side cable manager unit 36 further defines a coupling section which comprises at least one coupling element 114, 116, 118. In the present case, the rear-side cable manager unit 36 defines a coupling section comprising six coupling elements 114, 116, 118, in particular two first coupling elements 114, two second coupling elements 116 and two third coupling elements 118. The coupling elements 114, 116, 118 are arranged on a front side of the cable manager base body 112. Furthermore, the coupling elements 114, 116, 118 are arranged on a side of the cable manager base body 112 that faces towards the cable modules 22, 24, in particular towards a rear side of a respective cable module 22,24.

The first coupling elements 114 are at least substantially identical to each other. The first coupling elements 114 are embodied at least substantially bolt-shaped. With respect to a width of the rear-side cable manager unit 36, the first coupling elements 114 are respectively arranged in a proximity of opposite lateral sides of the cable manager base body 112.

The second coupling elements 116 are at least substantially identical to each other. The second coupling elements 116 are embodied at least substantially hook-shaped. The second coupling elements 116 are embodied as latching elements and/or snap-in elements. With respect to the width of the rear-side cable manager unit 36, the second coupling elements 116 are respectively arranged in a proximity of opposite lateral sides of the cable manager base body 112.

The third coupling elements 118 are at least substantially identical to each other. The third coupling elements 118 are embodied at least substantially hook-shaped. The third coupling elements 118 are embodied as latching elements and/or snap-in elements. With respect to the width of the rear-side cable manager unit 36, the third coupling elements 118 are respectively arranged in a proximity of opposite lateral sides of the cable manager base body 112. Moreover, the third coupling elements 118 are arranged such that a hook section of the third coupling elements 118 faces in an opposite direction than a hook section of the second coupling elements 116. Alternatively, it is however conceivable that a rear-side cable manager unit defines a coupling section comprising exactly one coupling element, two coupling elements or four coupling elements.

Beyond this, the rear-side cable manager unit 36 comprises a handle element 120. The handle element 120 is arranged on a rear side of the cable manager base body 112. The handle element 120 is arranged on a side of the cable manager base body 112 that faces away from the front side of the cable management unit 16. The handle element 120 is arranged on a side of the cable manager base body 112 that faces away from the cable modules 22, 24.

In addition, the rear-side cable manager unit 36 comprises a locking element 122. The locking element 122 is arranged on a rear side of the cable manager base body 112. The locking element 122 is arranged on a side of the cable manager base body 112 that faces away from the front side of the cable management unit 16. The locking element 122 is arranged on a side of the cable manager base body 112 that faces away from the cable modules 22, 24. The locking element 122 is embodied at least substantially hook-shaped. The locking element 122 is embodied as a latching element and/or snap-in element. The locking element 122 is configured to snap into one of the locking recesses 74 of the inner delimiting unit 32 in such a way that the rear-side cable manager unit 36 is in a mounted state securely connected to the inner delimiting unit 32 and/or the frame unit 30. For unlocking, the locking element 122 is movable in a vertical direction, in particular with respect to the width of the cable management unit 16. Principally, it is also conceivable to use two locking elements which are preferably arranged in a proximity of opposite lateral sides of a cable manager base body.

Furthermore, the rear-side cable manager unit 36 has a modular structure. The rear-side cable manager unit 36 may herein comprise several different further cable guiding elements 40, e.g. cable dividers, preferably of the types D12 and/or D23, and/or stress relief elements. The further cable guiding elements 40 are selectable from a group of further cable guiding elements 40 depending on an intended application of the rear-side cable manager unit 36, in particular depending on a cable type used and/or on an intended application of the cable module 22, 24. The further cable guiding elements 40 may, for example, be provided for avoiding pull tensions and/or for a fan-out of cables.

For this purpose, the rear-side cable manager unit 36 provides at least one further connection recess 38 located in the cable manager base body 112. In the present case, the rear-side cable manager unit 36 provides twelve further connection recesses 38 for selectively connecting the further cable guiding elements 40 in different positions. The further connection recesses 38 are embodied at least substantially identical to each other. In addition, the further connection recesses 38 are embodied at least substantially identical to the connection recesses 82. The further connection recesses 38 have a square shape with a standardized extension, which is in the present case in particular 9 mm x 9 mm. Moreover, the further connection recesses 38 are spaced apart from each other in such a way that a minimal distance between the further connection recesses 38 is between 5 cm and 6 cm in the depth direction of the cable management unit 16 and between 6 mm and 8 mm in the width direction of the cable management unit 16. Herein, at least three of the further connection recesses 38 are offset with respect to each other in the depth direction of the cable management unit 16. As an alternative, a rear-side cable manager unit may also comprise fixedly arranged further cable guiding elements. In addition, a rear-side cable manager unit may comprise at least four, eight or ten further connection recesses or any other suitable number of further connection recesses. Moreover, additionally and/or alternatively, a rear-side cable manager unit and in particular a cable manager base body may also define a cable overlength receiving region configured for receiving a cable overlength of at least one cable fed to a cable module.

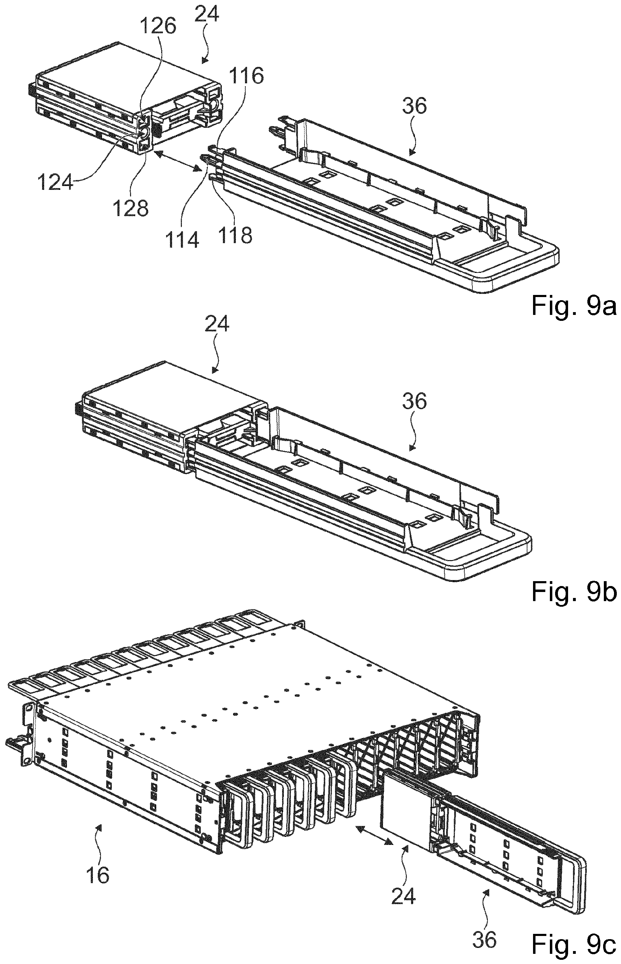

In the present case, the rear-side cable manager unit 36 is furthermore couplable to the cable module 22, 24 and/or one of the other cable modules 22, 24 for mounting and/or demounting the cable module 22, 24 in one of the module slots 20 from the rear side (cf. in particular figures 9a to 9c).

For the purpose of coupling the rear-side cable manager unit 36 with one of the cable modules 22, 24, the rear side of the cable module 22, 24, in particular the coupling section of the cable module 22, 24, is connected to a front side of the rear-side cable manager unit 36, in particular the coupling section of the rear-side cable manager unit 36. Herein, the coupling elements 114, 116, 118 couple with corresponding coupling elements 124, 126, 128, in the present case in particular coupling recesses, of the cable modules 22, 24 (cf. in particular figure 9a). In the present case, the coupling elements 114, 116, 118 engage into corresponding coupling elements 124, 126, 128. In the present case, the first coupling elements 114 are configured at least substantially for orienting the rear-side cable manager unit 36 with respect to the cable module 22, 24. Furthermore, the second coupling elements 116 and the third coupling elements 118 are configured for fastening the rear-side cable manager unit 36 to the cable module 22, 24. However, alternatively it is also conceivable that coupling elements of a rear-side cable manager unit are embodied as coupling recesses. It is moreover conceivable that a rear-side cable manager unit and a cable module comprise at least one coupling recess.

For mounting the cable module 22, 24 from the rear side, the cable module 22, 24 is connected to the rear-side cable manager unit 36 and then introduced into one of the module slots 20 by means of a linear movement of the rear-side cable manager unit 36 in particular until the locking element 122 snaps into one of the locking recesses 74 of the inner delimiting unit 32. Thus, the rear-side cable manager unit 36 and the cable module 22, 24 are in a mounted state securely connected to the inner delimiting unit 32 and/or the frame unit 30.

For demounting the cable module 22, 24 from the rear side, the locking element 122 has to be pushed, thus releasing the latch connection between the rear-side cable manager unit 36 and the inner delimiting unit 32 in such a way that the cable module 22, 24 can be removed, in particular pulled out, by means of the rear-side cable manager unit 36 and in particular by means of a linear movement of the rear-side cable manager unit 36.

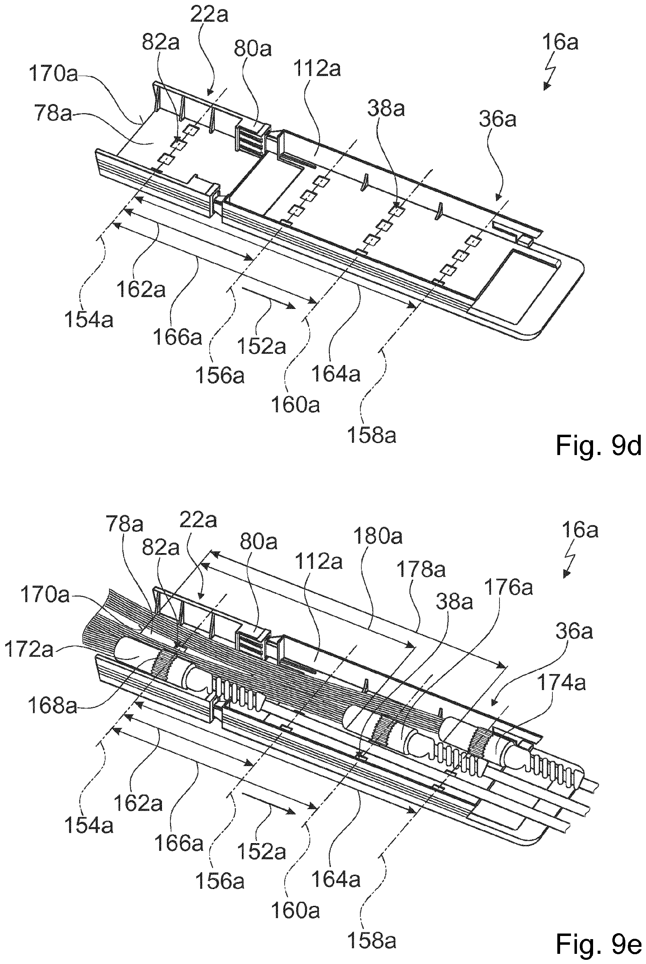

Figures 9d and 9e show an alternative rear-side cable manager unit 36a and an alternative cable module 22a of the cable management unit 16a in a mounted state. In the present case, the cable module 22a is configured at least for guiding at least one cable and/or for a fan-out of at least one cable. The cable module 22a comprises at least one connection recess 82a. In the present embodiment, the cable module 22a comprises four connection recesses 82a. The connection recesses 82a are embodied at least substantially and preferably completely identical. The connection recesses 82a have a square shape with a standardized extension, which is in the present case in particular 9 mm x 9 mm.

The connection recesses 82a are arranged in a row which is, in a mounted state of the cable module 22a and the rear-side cable manager unit 36a, in particular oriented perpendicular to a main direction of extension 152a of the cable module 22a and the rear-side cable manager unit 36a. The row of connection recesses 82a defines a reference line 154a. The reference line 154a is, in a mounted state of the cable module 22a and the rear-side cable manager unit 36a, in particular oriented perpendicular to a main direction of extension 152a of the cable module 22a and the rear-side cable manager unit 36a.

The connection recesses 82a are configured for fixing at least one cable and/or for a fan-out of at least one cable to a module base body 78a of the cable module 22a. For fixation of at least one cable and/or of a fan-out of at least one cable to the module base body 78a, the connection recesses 82a are configured for receiving at least one cable connector 168a. The cable connector 168a is in particular part of the cable management device 10a. The cable connector 168a fixes at least one cable and/or a fan-out of at least one cable to the module base body 78a, in a mounted state.

The rear-side cable manager unit 36a comprises at least one further connection recess 38a which is located in a cable manager base body 112a of the rear-side cable manager unit 36a. In the present case, the rear-side cable manager unit 36a comprises twelve further connection recesses 38a. The further connection recesses 38a are embodied at least substantially identical to each other. In addition, the further connection recesses 38a are embodied at least substantially identical to the connection recesses 82a. The further connection recesses 38a have a square shape with a standardized extension, which is in the present case in particular 9 mm x 9 mm.

The further connection recesses 38a are configured for fixing at least one cable and/or for a fan-out of at least one cable to the cable manager base body 112a. For fixation of at least one cable and/or of a fan-out of at least one cable to the cable manager base body 112a, the further connection recesses 38a are configured for receiving at least one cable connector 168a. The cable connector 168a is in particular part of the cable management device 10a. The cable connector 168a fixes at least one cable and/or a fan-out of at least one cable to the cable manager base body 112a, in a mounted state.

The further connection recesses 38a are arranged in three rows which are spaced apart from each other in a main direction of extension 152a of the cable module 22a and the rear-side cable manager unit 36a. Four of the further connection recesses 38a are arranged in one of the rows, respectively.

A first one of the rows of the further connection recesses 38a is arranged closest to reference line 154a, in particular defined by the connection recesses 82a of the cable module 22a, and defines a first reference line 156a. A second one of the rows of the further connection recesses 38a is arranged at a distance from reference line 154a, in particular defined by the connection recesses 82a of the cable module 22a, and defines a second reference line 158a. A third one of the rows of the further connection recesses 38a is arranged between the first reference line 156a and the second reference line 158a and defines a third reference line 160a.

In the present embodiment, the first reference line 156a and the reference line 154a are distanced in a main direction of extension 152a of the cable module 22a and the rear-side cable manager unit 36a by an extension 162a of approximately 135 mm. The second reference line 158a and the reference line 154a are distanced in a main direction of extension 152a of the cable module 22a and the rear-side cable manager unit 36a by an extension 164a of approximately 260 mm. The third reference line 160a and the reference line 154a are distanced in a main direction of extension 152a of the cable module 22a and the rear-side cable manager unit 36a by an extension 166a of approximately 195 mm.

The cable module 22a comprises a first end 170a. The first end 170a is located at a side of the cable module 22a which faces away from the rear-side cable manager unit 36a, in a connected state of the cable module 22a and the rear-side cable manager unit 36a. In a mounted state, in which a first cable 172a is connected to the cable module 22a, in particular via the cable connector 168a, the first cable 172a is fixed to the cable module 22a in such a way that a fan-out of the first cable 172a overlaps with the first end 170a of the cable module 22a.

Figure 9e shows an example in which a second cable 174a and a third cable 176a are connected to the rear-side cable manager unit 36a. The second cable 174a is connected to further connection recesses 38a defining the second reference line 158a. A distance 178a of a fan-out of the second cable 174a to the first end 170a is approximately 260 mm. The distance 178a of a fan-out of the second cable 174a to the first end 170a and the extension 164a between the second reference line 158a and the reference line 154a are approximately identical.

The third cable 176a is connected to further connection recesses 38a defining the third reference line 160a. A distance 180a of a fan-out of the third cable 176a to the first end 170a is approximately 195 mm. The distance 180a of a fan-out of the third cable 176a to the first end 170a and the extension 166a between the third reference line 160a and the reference line 154a are approximately identical.

The different extensions 162a, 164a, 166a and/or the different distances 178a, 180a can in particular be used to adjust a given fan-out to different locations of ports on a port group. In particular, instead of requiring different assemblies with different fan-out extensions, the same type of assembly with different locations of fixation can in particular be used.

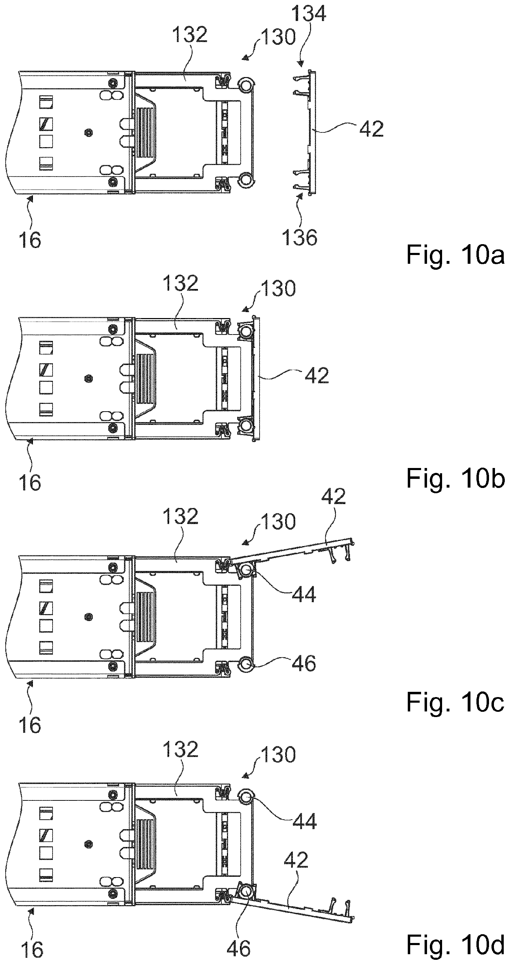

Moreover, for the purpose of covering and/or protecting the receiving region 18 and in particular the module slots 20, the cable management unit 16 further comprises a protective unit 130 (cf. figure 1 as well as figures 10a to 10d). The protective unit 130 is arranged in a region of the front side of the cable management unit 16. The protective unit 130 is embodied separately from the inner delimiting unit 32 and/or the frame unit 30.

The protective unit 130 comprises the at least one protective holder 132. The protective holder 132 is made at least largely of plastic. The protective holder 132 is in a mounted state connected to the frame unit 30 and/or the inner delimiting unit 32. Therefore, the protective holder 132 is stationary and/or immovable with respect to the frame unit 30 and/or the inner delimiting unit 32, in a mounted state. Moreover, the protective holder 132 protrudes away from a front side of the frame unit 30 in particular such that the protective holder 132 covers the front-side cable manager units 34 at least if viewed in a direction that is perpendicular to the side walls 60. Herein, the protective holder 132 is at least substantially rectangular at least if viewed in a direction perpendicular to the side walls 60. As an alternative it is, however, also conceivable to manufacture a protective holder at least partly of a material that differs from a plastic material, e.g. a metal and/or a composite material. Moreover, a protective holder may be connected to a frame unit and/or an inner delimiting unit in a one-part implementation.

The protective unit 130 further comprises a protective element 42. The protective element 42 is at least partly made of plastic. The protective element 42 is embodied at least substantially rectangular, in particular if viewed perpendicularly to a main extension plane of the protective element 42. The protective element 42 is herein embodied as a protective plate (cf. also figure 1). The protective element 42 is at least substantially plate-shaped. The protective element 42 has a height that is adapted to the height of the frame unit 30. Moreover, the protective element 42 has a width that is adapted to the width of the frame unit 30. Herein, the protective element 42 is selectable from a group of protective elements 42 depending on a width and/or a height of the frame unit 30.

The protective element 42 can be coupled to the protective holder 132. Herein, the protective element 42 is connectable to and removable from the protective holder 132 without tools and in particular in a non-destructive manner. The protective element 42 is thus detachably connected to the protective holder 132 in at least one operating state.

For this purpose, the protective element 42 comprises at least two connecting elements 134, 136. The connecting elements 134, 136 are embodied at least substantially identically to each other. The connecting elements 134, 136 are offset with respect to each other in the vertical direction. The connecting elements 134, 136 are at least substantially C-shaped and/or U-shaped. The connecting elements 134, 136 are embodied as latching elements and/or snap-fit elements. Principally, connecting elements could also be embodied as screw elements or the like.

In addition, the protective element 42 comprises a sight region 138 (cf. figure 1). The sight region 138 is embodied at least substantially transparent. The sight region 138 extends at least substantially over an entire width of the frame unit 30. The sight region 138 is configured to allow a view onto the receiving region 18 and/or onto the cable modules 22, 24.

Beyond this, the protective element 42 is pivotably supported in particular by way of at least one hinge. The protective element 42 is herein supported in such a way that it is pivotable with respect to the frame unit 30 about at least one horizontally aligned pivot axis 44, 46 that extends in a direction of the width of the frame unit 30. In the present case, the protective element 42 is supported in such a way that it is pivotable about two different horizontally aligned pivot axes 44, 46 with respect to the frame unit 30. Herein, the pivot axes 44, 46 are offset in a vertical direction with respect to each other. Alternatively it is, however, also conceivable that a protective element is pivotable about merely one horizontally aligned pivot axis and/or at least one vertically aligned pivot axis.

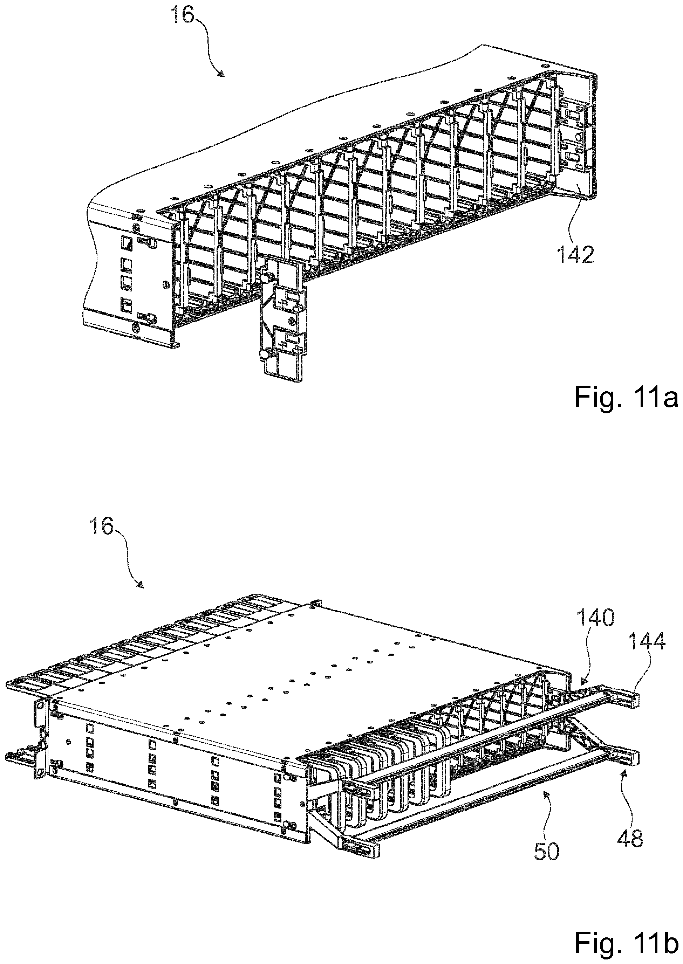

The cable management unit 16 further comprises a plurality of functional units 50, in particular electrical and/or electronical control units and/or monitoring units, as well as at least one functional unit receiving zone 48 for the functional units 50 (cf. in particular figures 11 a and 11 b).

For this purpose, the cable management unit 16 comprises a support unit 140. The support unit 140 is made of plastic. The support unit 140 is arranged in a region of the rear side of the cable management unit 16. The support unit 140 is embodied separately from the inner delimiting unit 32 and/or the frame unit 30. As an alternative it is, however, also conceivable to manufacture a support unit at least partly of a material that differs from a plastic material, e.g. a metal and/or a composite material.

The support unit 140 comprises at least one first support element 142. In the present case, the support unit 140 comprises two first support elements 142. The first support elements 142 are at least substantially identical to each other. The first support elements 142 are respectively embodied at least substantially rectangular, in particular if viewed perpendicularly to a main extension plane of the first support elements 142. The first support elements 142 are embodied as support plates. The first support elements 142 are embodied as adapter elements. With respect to a width of the frame unit 30, the first support elements 142 are respectively arranged in a proximity of opposite lateral sides of the frame unit 30. The first support elements 142 directly contact the frame unit 30, in a mounted state. The first support elements 142 are connected to the frame unit 30, in a mounted state. Therefore, the first support elements 142 are in a mounted state stationary and/or immovable with respect to the frame unit 30. Principally it is, however, also conceivable to dispense with first support elements.

The support unit 140 further comprises at least one second support element 144. In the present case, the support unit 140 comprises four second support elements 144. The second support elements 144 are at least substantially identical to each other. The second support elements 144 are embodied as holding arms protruding away from a rear side of the frame unit 30. With respect to a width of the frame unit 30, two of the second support elements 144 are respectively arranged in a proximity of opposite lateral sides of the frame unit 30. The second support elements 144 are in a mounted state connected to the first support elements 142. Herein, the second support elements 144 form or define the functional unit receiving zone 48 for the functional units 50. As an alternative it is, however, also conceivable to dispense with additional functional units and/or functional unit receiving zones, and/or to provide further functional units and/or further functional unit receiving zones.

In particular for the purpose of ensuring an especially secure fastening of the cable management unit 16 on the carrier unit 56, the cable management device 10 comprises at least one fastening element 146, 148 (cf. in particular figures 12a and 12b). Herein, figure 12a shows first fastening elements 146 of a first type, which are in particular used for a horizontal installation of the cable management unit 16, while figure 12b shows second fastening elements 148 of a second type, which are in particular used for a vertical installation of the cable management unit 16. The fastening elements 146, 148 are herein selectable from a group of fastening elements 146, 148, depending on an application purpose of the cable management unit 16.

The first fastening elements 146 are configured for a horizontal installation of the cable management unit 16. The first fastening elements 146 are embodied at least substantially identical to each other. The first fastening elements 146 are in the present case made of metal. The first fastening elements 146 are embodied at least substantially rectangular, in particular if viewed perpendicularly to a main extension plane of the first fastening elements 146. The first fastening elements 146 are embodied at least substantially L-shaped. In a mounted state, a large side of the first fastening elements 146 and/or the L-shape respectively forms and/or defines a holding section for holding the cable management unit 16. Furthermore, a small side of the first fastening elements 146 and/or the L-shape respectively defines a fastening section for fastening the first fastening elements 146 to the carrier unit 56. The first fastening elements 146 are in the mounted state arranged in the region of the rear side of the cable management unit 16. The first fastening elements 146 are configured to support the cable management unit 16 in the region of its rear side and to at least partially transfer a weight force of the cable management unit 16 onto the carrier unit 56. In the present case, the first fastening elements 146 are provided to prevent a rearward sagging of the cable management unit 16. Moreover, the first fastening elements 146 are configured for allowing a usage of the cable management unit 16 with different carrier units 56 featuring depths between 800 and 1000 mm. In addition, the first fastening elements 146 are configured for a cable guidance and/or for receiving at least one cable guiding element, e.g. the aforementioned cable guiding element 84 and/or further cable guiding element 40. For this purpose, the first fastening elements 146 comprise at least one additional connection recess 150. As an alternative it is, however, also conceivable to dispense with first fastening elements. Moreover, it is also conceivable to manufacture a first fastening element at least partly of a material that differs from a metal, e.g. a plastic and/or a composite material.

The second fastening elements 148 are configured for a vertical installation of the cable management unit 16. The second fastening elements 148 are embodied at least substantially identically to each other. The second fastening elements 148 are in the present case made of metal. The second fastening elements 148 are embodied at least substantially L-shaped. In a mounted state, a small side of the second fastening elements 148 and/or the L-shape respectively forms and/or defines a holding section for holding the cable management unit 16. Furthermore, a large side of the second fastening elements 148 and/or the L-shape respectively defines a fastening section for fastening the second fastening elements 148 to the carrier unit 56. The second fastening elements 148 are in the mounted state arranged in the region of the front side of the cable management unit 16. The second fastening elements 148 are configured to support the cable management unit 16 in the region of its front side and to at least partially transfer a weight force of the cable management unit 16 onto the carrier unit 56. As an alternative it is, however, also conceivable to dispense with second fastening elements. Moreover, it is also conceivable to manufacture a second fastening element at least partly of a material that differs from a metal, e.g. a plastic and/or a composite material.

## Claims

1. A cable management device (10), in particular for use in conjunction with a network switch (12) and/or a patch panel (14), comprising at least one cable management unit (16) which has a modular structure and defines at least one receiving region (18) with at least one vertically aligned module slot (20) for receiving at least one cable module (22, 24).

2. The cable management device (10) according to claim 1, **characterised in that** the module slot (20) is configured to support at least two different types of cable modules (22, 24).

3. The cable management device (10) according to claim 1 or 2, **characterised in that** the cable management unit (16) comprises at least one first cable module (22) located, in a mounted state, in the receiving region (18), wherein the first cable module (22) is embodied as a direct-connection module and configured at least for guiding at least one cable.

4. The cable management device (10) according to any one of the preceding claims, **characterised in that** the cable management unit (16) comprises at least one second cable module (24) located, in a mounted state, in the receiving region (18), wherein the second cable module (24) is embodied as an interconnection module having at least one connector (26, 28).

5. The cable management device (10) according to any one of the preceding claims, **characterised in that** the module slot (20) is at least configured for mounting and/or demounting the cable module (22, 24) from a rear side.

6. The cable management device (10) according to any one of the preceding claims, **characterised in that** the receiving region (18) extends at least largely over an entire width of the cable management unit (16) and comprises at least ten vertically aligned module slots (20).

7. The cable management device (10) according to any one of the preceding claims, **characterised in that** the cable management unit (16) comprises at least one frame unit (30) and at least one inner delimiting unit (32) adjoining the frame unit (30) and delimiting the receiving region (18), in particular the module slot (20).

8. The cable management device (10) according to any one of the preceding claims, **characterised in that** the cable management unit (16) comprises at least one front-side cable manager unit (34), which is configured in at least one operating state to feed at least one cable to a front side of the cable module (22, 24).

9. The cable management device (10) at least according to claims 7 and 8, **characterised in that** the front-side cable manager unit (34) is connected to the inner delimiting unit (32).

10. The cable management device (10) according to any one of the preceding claims, **characterised in that** the cable management unit (16) comprises at least one rear-side cable manager unit (36), which is configured in at least one operating state to feed at least one cable to a rear side of the cable module (22, 24).

11. The cable management device (10) according to claim 10, **characterised in that** the rear-side cable manager unit (36) is couplable to the cable module (22, 24) for mounting and/or demounting of the cable module (22, 24).

12. The cable management device (10) according to claim 10 or 11, **characterised in that** the rear-side cable manager unit (36) has a modular structure.

13. The cable management device (10) according to one of claims 10 to 12, **characterised in that** the rear-side cable manager unit (36) provides at least four connection recesses (38) for selectively connecting cable guiding elements (40) in different positions.

14. The cable management device (10) according to any one of the preceding claims, **characterised in that** the cable management unit (16) comprises at least one protective element (42), which is configured in at least one operating state to at least partly cover the receiving region (18) and which is pivotable about two different horizontally aligned pivot axes (44, 46) which are offset in a vertical direction with respect to each other.

15. A cable management system (52) with at least one cable management device (10) according to one of the preceding claims.
